# EUROPEAN PATENT APPLICATION

(11) **EP 1 130 624 A2**
(43) Date of publication of application: **05.09.2001**
(21) Application number: 01301685.2
(22) Date of filing: 23.02.2001
(51) Int. Cl.: H01J 37/32

(54) **Coil and coil support for generating a plasma**

(30) Priority: 29.02.2000 US 515880
(71) Applicant: Applied Materials, Inc., Santa Clara, California 95054-3299 (US)
(72) Inventor: Pancham, Ian, San Francisco, CA 94110 (US); Rosenstein, Michael, Sunnyvale, CA 94087 (US); De Laurentis, Leif Eric, Boulder Creek, CA 95006 (US); Lau, Allen, San Jose, CA 95132 (US); Gopalraja, Praburam, San Jose, CA 95131 (US); Van Gogh, James, Sunnyvale, CA 94087 (US)
(74) Representative: Cross, Rupert Edward Blount

(57) **Abstract**

A coil (104) has an integral fastener portion (500) to facilitate fastening the coil to a shield wall (140) to reduce generation of particulates.

## Description

### FIELD OF THE INVENTION

The present invention relates to plasma generators, and more particularly, to a method and apparatus for generating a plasma in the fabrication of semiconductor devices.

### BACKGROUND OF THE INVENTION

Radio frequency (RF) generated plasmas have become convenient sources of energetic ions and activated atoms which can be employed in a variety of semiconductor device fabrication processes including surface treatments, depositions, and etching processes. For example, to deposit materials onto a semiconductor wafer, substrate, or other workpiece using a sputter deposition process, a plasma is produced in the vicinity of a sputter target material which is negatively biased. Ions created within the plasma impact the surface of the target to dislodge, i.e., "sputter" material from the target. The sputtered materials are then transported and deposited on the surface of the semiconductor wafer.

Sputtered material has a tendency to travel in paths from the target to the substrate being deposited at angles which are oblique to the surface of the substrate. As a consequence, materials deposited in etched trenches and holes of semiconductor devices having trenches or holes with a high depth to width aspect ratio, can bridge over causing undesirable cavities in the deposition layer. To prevent such cavities, the sputtered material can be redirected into substantially vertical paths between the target and the substrate by negatively charging the substrate or substrate support if the sputtered material is sufficiently ionized by the plasma. However, material sputtered in a low density plasma often has an ionization degree of less than 1% which may be insufficient to avoid the formation of an excessive number of cavities. Accordingly, in some applications, it is desirable to increase the ionization rate of the sputtered material in order to decrease the formation degree of unwanted cavities in the deposition layer.

One technique for increasing the ionization rate is to inductively couple RF energy from a coil to a plasma between the target and the workpiece. In order to maximize the energy being coupled from the coil to the plasma, it is desirable to position the coil as close as possible to the plasma itself. At the same time, however, it is also desirable to minimize the number of chamber fittings and other parts exposed to the material being sputtered so as to facilitate cleaning the interior of the chamber and to minimize the generation of particles being shed from interior surfaces. These particles shed from interior surfaces can fall on the wafer itself and contaminate the product. Accordingly, many sputtering chambers have a generally annular-shaped shield enclosing the plasma generation area between the target and the pedestal supporting the wafer. The shield provides a smooth gently curved surface which is relatively easy to clean and protects the interior of the chamber from being deposited with the sputtering material.

Thus, on the one hand, it would be desirable to place the coil outside the shield so that the coil is shielded from the material being deposited. Such an arrangement would minimize generation of particles by the coil and its supporting structure and would facilitate cleaning of the chamber. On the other hand, it is desirable to place the coil as close as possible to the plasma generation area inside the shield to avoid any attenuation by the spacing from the plasma or by the shield itself to thereby maximize energy transfer from the coil to the plasma. Accordingly, it has been difficult to increase energy transfer from the coil to the plasma while at the same time minimizing particle generation.

### SUMMARY OF THE PREFERRED EMBODIMENTS

In accordance with one aspect of the invention, a coil is carried internally in a semiconductor fabrication chamber by a plurality of novel coil standoffs and RF feedthrough standoffs which reduce generation of particulates. In the illustrated embodiment, the coil has an outer face facing a shield wall, in which the outer face defines a fastener recess extending partially through the coil. A standoff includes a fastener member adapted to fasten the coil to the shield wall. The coil outer face fastener recess is adapted to receive the fastener member. As explained below, such an arrangement can reduce the generation of particulates by the coil and the coil standoffs.

There are additional aspects to the present inventions as discussed below. It should therefore be understood that the preceding is merely a brief summary of one embodiment of the present inventions. It should further be understood that numerous changes to the disclosed embodiments can be made without departing from the spirit or scope of the inventions. The preceding summary, therefore is not meant to limit the scope of the inventions. Rather, the scope of the inventions are to be determined only by the appended claims and their equivalents.

### BRIEF DESCRIPTION OF THE DRAWINGS

Fig. 1 is a perspective, partial cross-sectional view of a plasma generating chamber in accordance with one embodiment of the present invention.

Fig. 2 is a partial cross-sectional view of the plasma generating chamber of Fig. 1 shown installed in a vacuum chamber.

Fig. 3 is a schematic diagram of the electrical interconnections to the plasma generating chamber of Fig. 1.

Fig. 4 is a cross-sectional view of a coil standoff of the plasma generating chamber of Fig. 2.

Fig. 5 is a cross-sectional view of a coil feedthrough standoff of the plasma generating chamber of Fig. 2.

Fig. 6 is a perspective view of a coil feedthrough standoff of Fig. 1.

Fig. 7 is a top schematic view of the coil of Fig. 1.

### DETAILED DESCRIPTION OF THE DRAWINGS

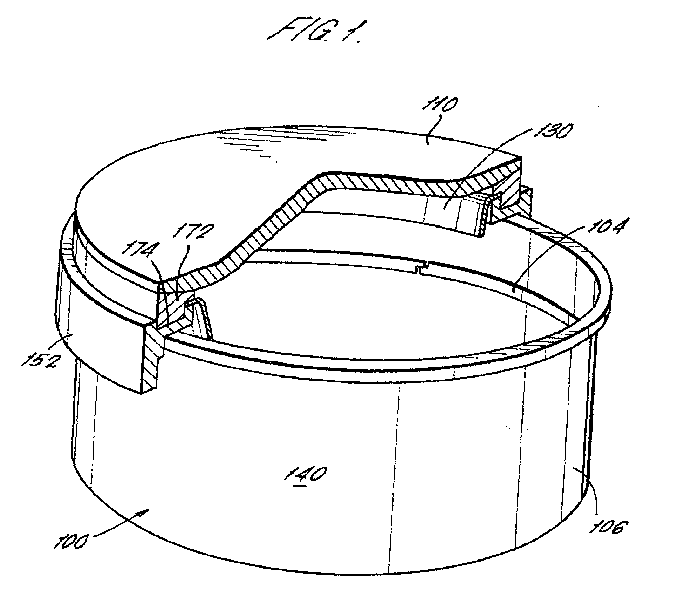

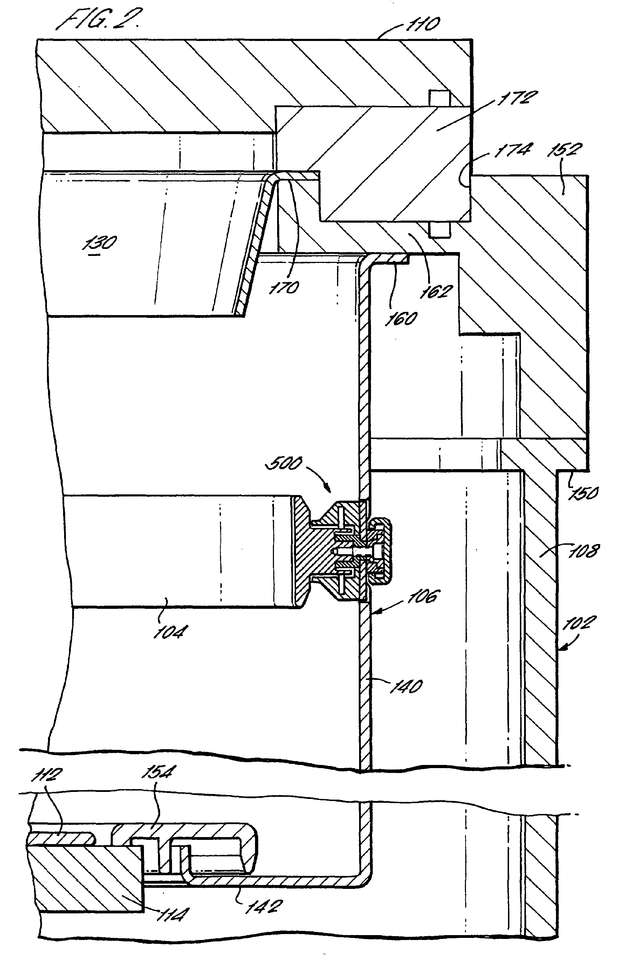

Referring first to Figs. 1 and 2, a plasma generator in accordance with a first embodiment of the present invention comprises a substantially cylindrical plasma generating chamber 100 which is maintainable at vacuum in a vacuum chamber 102 (Fig. 2). The plasma chamber 100 in this embodiment has a single-turn coil 104 which is carried internally by a shield 106. The shield 106 protects the interior walls 108 (Fig. 2) of the vacuum chamber 102 from the material being deposited within the interior of the plasma chamber 100.

Radio frequency (RF) energy from an RF generator is radiated from the coil 104 into the interior of the plasma chamber 100, which energizes a plasma within the plasma containment region of the plasma chamber 100. A plasma ion flux strikes a negatively biased target 110 positioned above the plasma chamber 100. The plasma ions eject material from the target 110, which may then be deposited onto a wafer or other substrate or workpiece 112 supported by a pedestal 114 at the bottom of the plasma chamber 100. Deposition material may also be sputtered from the coil 104 onto the substrate to supplement the deposition material from the target 110. The coil 104 is carried on the shield 106 by a plurality of novel coil standoffs 500 which electrically insulate the coil 104 from the supporting shield 106. In addition, the standoffs 500 permit repeated deposition of conductive materials from the target 110 onto the coil standoffs 500 while preventing the formation of a complete conducting path of deposited material from the coil 104 to the shield 106 which could short the coil 104 to the shield 106 (which is typically at ground). As will be explained in greater detail below, in accordance with one aspect of the present invention, the insulating coil support standoffs 500 support the coil 104 in a manner which reduces the generation of particulate matter from the face of the coil 104.

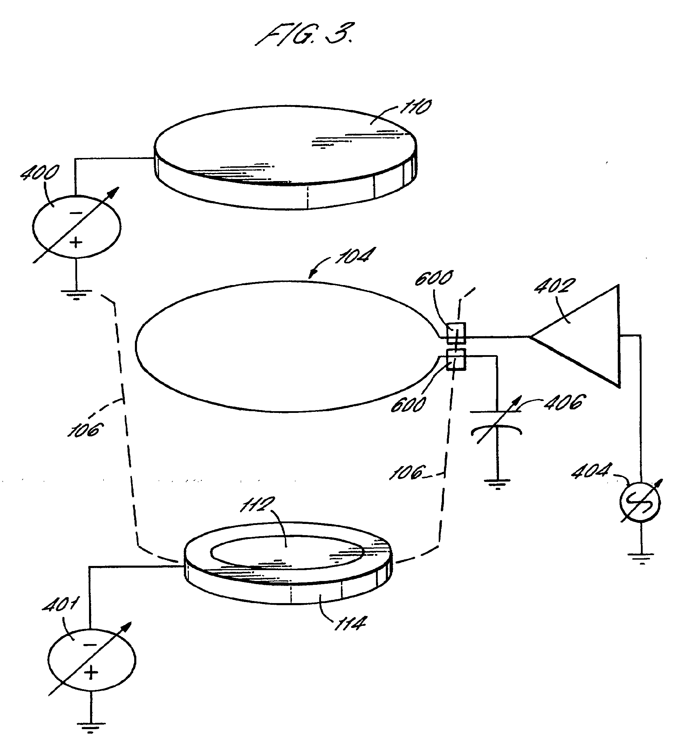

To enable use of the coil as a circuit path, RF power is passed through the vacuum chamber walls and through the shield 106 to ends of the coil 104. Vacuum feedthroughs (not shown) extend through the vacuum chamber wall to provide RF current from a generator preferably located outside the vacuum pressure chamber. RF power is applied through the shield 106 to the coil 104 by feedthrough standoffs 600 (Fig. 3) which like the coil standoffs 500, reduce the generation of particulate matter by the coil 104.

Fig. 2 shows the plasma chamber 100 installed in the vacuum chamber 102 of a PVD (physical vapor deposition) system. Although the plasma generator of the present invention is described in connection with a PVD system for illustration purposes, it should be appreciated that a plasma generator in accordance with the present invention is suitable for use with all other semiconductor fabrication processes utilizing a plasma including plasma etch, chemical vapor deposition (CVD) and various surface treatment processes.

As best seen in Fig. 2, the plasma chamber 100 has a dark space shield ring 130 which provides a ground plane with respect to the target 110 above which is negatively biased. In addition, the shield ring 130 shields the outer edges of the target from the plasma to reduce sputtering of the target outer edges. The dark space shield 130 performs yet another function in that it is positioned to shield the coil 104 and the coil support standoffs 500 and feedthrough standoffs 600 (Fig. 3) to an extent from the material being sputtered from the target 110.

In the illustrated embodiment, the dark space shield 130 is a closed continuous ring of titanium or stainless steel having a generally inverted frusto-conical shape. It is recognized, of course, that the dark space shield may be made from a variety of other conductive materials and have other shapes which shield the coil 104 and its associated supporting structures from at least some of the material being deposited from the target.

The plasma chamber shield 106 is generally bowl-shaped and includes a generally cylindrically shaped, vertically oriented wall 140 to which the standoffs 500 and 600 are attached to insulatively support the coil 104. The shield further has a generally annular-shaped floor wall 142 which surrounds the chuck or pedestal 114 which supports the workpiece 112. A clamp ring 154 clamps the wafer to the chuck 114 and covers the gap between the floor wall 142 of the shield 106 and the chuck 114. Thus, it is apparent from Fig. 2 that the plasma chamber shield 106 together with the clamp ring 154 protects the interior of the vacuum chamber 102 from the deposition materials being deposited on the workpiece 112 in the plasma chamber 100. In an alternative embodiment, the shield 106 and dark space shield 130 may be connected together or integrally formed.

The vacuum chamber wall 108 has an upper annular flange 150. The plasma chamber 100 is supported by a vacuum chamber adapter ring assembly 152 which engages the vacuum chamber wall flange 150. The plasma chamber shield 106 has a horizontally extending outer flange member 160 which is fastened by a plurality of fastener screws (not shown) to a horizontally extending flange member 162 of the adapter ring assembly 152. The plasma chamber shield 106 is grounded to the system ground through the adapter ring assembly 152.

The dark space shield 130 also has an upper flange 170 which is fastened to the horizontal flange 162 of the adapter ring assembly 152. The dark space shield 130, like the plasma chamber shield 106, is grounded through the adapter ring assembly 152. It should be appreciated that there are numerous alternatives for supporting a shield and dark space shield within a chamber.

The target 110 is generally disk-shaped and is also supported by the adapter ring assembly 152. However, the target 110 is negatively biased and therefore should be insulated from the adapter ring assembly 152 which is at ground. Accordingly, seated in a circular channel formed in the underside of the target 110 is a ceramic insulation ring assembly 172 which is also seated in a corresponding channel 174 in the upper side of the target 110. The insulator ring assembly 174 which may be made of a variety of insulative materials including ceramics, spaces the target 110 from the adapter ring assembly 152 so that the target 110 may be adequately negatively biased. The target, adapter and ceramic ring assembly are provided with O-ring sealing surfaces (not shown) to provide a vacuum tight assembly from the vacuum chamber flange 150 to the target 110.

Fig. 3 is a schematic representation of the electrical connections of the plasma generating apparatus of the illustrated embodiment. To attract the ions generated by the plasma, the target 110 is preferably negatively biased by a variable DC power source 400 at a DC power of 3 kW. In the same manner, the pedestal 114 may be negatively biased by a source 401 at -30 v DC to negatively biased the substrate 112 to attract the ionized deposition material to the substrate. One end of the coil 104 is insulatively coupled through the shield 106 by a feedthrough standoff 600 to an RF source such as the output of an amplifier and matching network 402. The input of the matching network 402 is coupled to an RF generator 404 which provides RF power at approximately 4.5 kW for this embodiment. The other end of the coil 104 is also insulatively coupled through the shield 106 by a similar feedthrough standoff 600 to ground, preferably through a blocking capacitor 406 which may be a variable capacitor, to provide a DC bias on the coil 104. The power level may vary of course, depending upon the particular application.

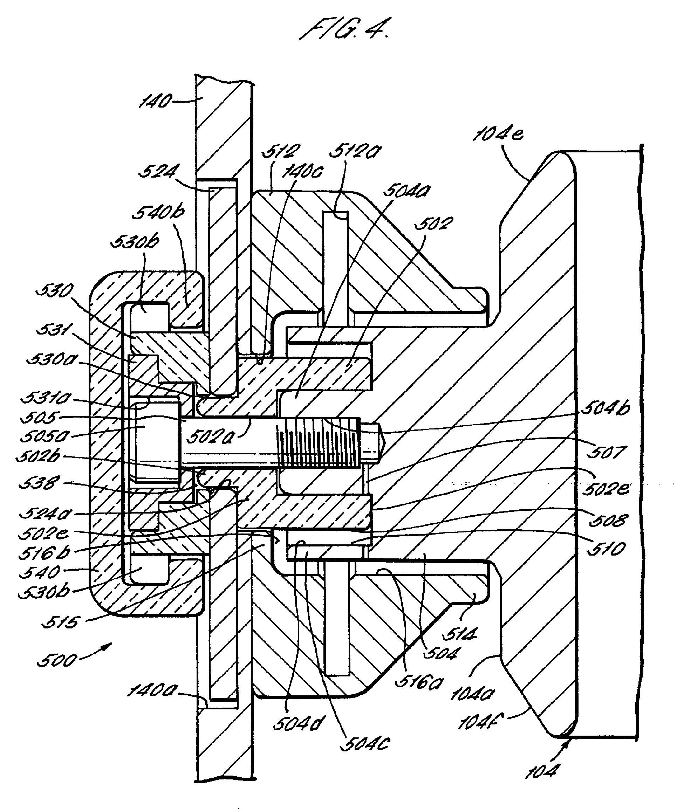

As set forth in greater detail in copending application Serial No. 08/680,335, entitled Sputtering Coil for Generating a Plasma, filed July 10, 1996 (Attorney Docket 1390-CIP/PVD/DV) and assigned to the assignee of the present application, the coil 104 may also be positioned and biased in such a manner that the coil may sputter as well as the target. As a result, the deposited material may be contributed by both the target and the coil. Such an arrangement has been found to improve the uniformity of the deposited layer. In addition, the coil may have a plurality of turns formed in a helix or spiral or may have as few turns as a single turn to reduce complexity and costs and facilitate cleaning. Turning now to Fig. 4, the internal structure of a coil standoff 500 in accordance with one aspect of the present invention is shown in greater detail. In the embodiment of Fig. 4, the standoff 500 includes a cylindrical electrically insulative base member 502 which is preferably made of an electrically insulative dielectric material such as a ceramic. Covering and shielding the base member 502 is a a cup-shaped metal hub member 504 which is attached to the rear or outer face 104a of the coil 104. In the illustrated embodiment, the hub member 504 protrudes radially outward from the back face 104a of the coil toward the shield wall 140. In addition, the hub member 504 is attached to the coil by welding. It is appreciated that the hub may be attached to the coil by alternative methods including brazing. Alternatively, the coil 104 and each hub member 504 may be fabricated as a one piece structure.

The hub member 504 has a central portion 504a which defines a threaded bore 504b which receives a fastener member which, in the illustrated embodiment, is a bolt 505 used to secure the coil 104 to the shield wall 140. It should be appreciated that the bore 504b is preferably formed as a recess on the rear face 104a of the coil 104, in which the recess 504b extends partially through the hub member 504 and does not extend entirely through the coil 104. As a consequence, the front or inner face 104b of the coil 104 facing the wafer and the plasma generation area above the wafer is free of any protruding fastener elements or fastener openings which could generate particulates.

As noted above, the fastener member 505 in the illustrated embodiment is a bolt which is received in the fastener recess 504b which, in the illustrated embodiment, is a threaded bore. It should be appreciated that other types of couplers and fastener members may be used including pins, clips, cams and other structures for mechanically coupling elements together. In addition, the coil 104 may have a male portion of the coupler or fastener such as a bolt, and the standoff may include a female portion of the coupler or fastener, such as a threaded bore.

A channel 507 through the central portion 504a and a side wall 504c of the hub member 504 is coupled to the threaded bore 504b for the bolt 505 to vent gases that might inadvertently be trapped by the bolt 505 in the bore 504b. The electrically insulative base member 502 insulates the hub member 504 which is at the same RF potential as the coil 104, from the shield wall 140 which, in the illustrated embodiment, is at ground potential. The bolt 505 passes through a central aperture 502a of the base member 502 such that the base member 502 also insulates the bolt 505 from the grounded shield wall 140.

The cylindrically shaped end 502c of the insulative base member 502 is received in an annular shaped channel 504d positioned between a side wall 504c and the central portion 504a of the hub member 504. The cylindrically shaped side wall 504c of the hub member 504 is spaced from the lateral side 508 of the base member 502 to form a labyrinthine passageway 510 oriented substantially transverse to the wall 140 of the shield. It is believed that for many applications, the passage way 510 of the standoff 500 inhibits the formation of a path of deposition material across the standoff which could short the coil 104 to the shield 106.

The standoff 500 of Fig. 4 comprises a second generally cup-shaped metal cover member 512 having a cylindrically shaped side wall 514 spaced from the side 504c of the cup-shaped hub member 502 to form a second labyrinthine passageway 516a oriented generally parallel to the passageway 510. The cover member 512 has a bottom interior wall 515 spaced from the end of the side wall 504c of the member 504 to define a third labyrinthine passageway 516b oriented generally transverse to and coupling the passageway 516a to the passageway 510 to further reduce the likelihood of the formation of a shorting conductive path.

The second cup-shaped cover member 512, spaced from the first hub cover member 504, is maintained at ground. On the other hand, the hub member 504 is affixed to the rear face 104a of the coil 104. Consequently, as mentioned above, the hub member 504 is at the same potential as the coil 104 and hence may sputter. Because the second cover member 512 is at ground potential and is positioned to cover most of the exposed surfaces of the hub member 504, it is believed that the second cover member 512 can substantially reduce sputtering of the hub member 504 in those applications in which sputtering of the standoffs is undesirable. Even in those applications in which the coil 104 is sputtered to enhance the uniformity of deposition on the substrate, sputtering of the standoffs may introduce nonuniformities since the standoffs are typically not arrayed in a continuous ring around the substrate. Hence, retarding sputtering of the standoffs may be useful in a number of applications.

The insulative base member 502 extends through an opening 140c in the shield wall 140. In addition, the base member 502 has a reduced diameter portion 502b which extends through an opening 524a of a retainer plate 524 received in a recess 140a on the outer side of the shield wall 140.

The second cover member 512 and the retainer plate 524 are fastened to opposite sides of the shield wall 140 by screws or other suitable fasteners to support the feedthrough 500 on the shield wall 140. In addition, the cover member fasteners ensure that the second cover member 512 is tightly engaged against and in good electrical contact with the shield wall 140 and therefore grounded to retard sputtering of the second cover member 512. An annular shaped channel 512a in the second cover member is coupled to the threaded holes for the fasteners to vent gases that might inadvertently be trapped in the fastener holes.

The reduced diameter portion 502b of the base member 502 also extends through an opening 530a of a second electrically insulative base member 530 positioned on the outer side of the shield wall 140. Seated in a metal sleeve or bushing 531 is the bolt 505 which passes through an interior opening 531a in the sleeve 531, and the central aperture 502a of the base member 502 and is threaded into the threaded bore 504b of the hub member 504. A shoulder 502e of the insulative base member 502 which is received in the annular shaped channel 504d of the hub member 504, compresses the retainer plate 524 on one side as the bolt 505 is threaded into the hub member 504. The second electrically insulative member 530 compresses the retainer plate on the other side as the head 505a of the bolt 505 compresses the bushing 531 against the second insulative base member 530. In this manner, tightening the bolt 505 compresses the assembly of the standoff 500 together to insulatively secure the standoff and coil 104 to the shield wall 140.

The first electrically insulative base member 502 electrically insulates the hub member 504 of the coil 104 and the bolt 505 from the grounded shield wall 140. However, the base member 502 is preferably formed from an electrically insulative material which is also a good thermal conductor. The RF coil 104 may generate substantial heat which can be thermally coupled by the electrical insulator base member 502 to the wall 140 of the shield 106 to be dissipated. In the illustrated embodiment, the base member 502 is formed from an aluminum nitride ceramic material. Other electrically insulative materials may be used but it is preferred that the material be a good thermal conductor as well. Additional electrically insulative materials include aluminum oxide ceramic and quartz.

A space 538 is provided between the end of the reduced diameter portion 502b and the bushing 531 so that the compressive force of the bolt 532 and the hub member 504 does not damage the insulative members which may be made of breakable materials such as ceramics. The end of the bolt 505 may be covered by a third electrically insulative member 540 which, in the illustrated embodiment is button-shaped. The second insulative base member 530 has a flange 530b spaced from the retaining plate which receives a lip 540b of the insulative cover member 540 to retain the cover member 540 in place.

The insulative base member 530 and the insulative member 540 may be made of electrically insulative materials including ceramic materials such as aluminum oxide. Alternatively, electrically insulative materials which are also good thermal conductors may be used such as aluminum nitride ceramics.

The coil 104 and the hub members 504 of the coil 104 are preferably made of the same material which is being deposited. Hence, if the material being deposited is made of titanium, the hub member 504 is preferably made of titanium as well. To facilitate adherence of the deposited material (here for example, titanium), exposed surfaces of the metal may be treated by bead blasting which will reduce shedding of particles from the deposited material. Besides titanium, the coil and target may be made from a variety of deposition materials including tantalum, copper, and tungsten.

The passageways 510, 516a and 516b form a labyrinth between the standoff components including the hub member 504 of the coil 104, the insulative member 502 and the cover member 512. As set forth in greater detail in copending application Serial No. 08/853,024, filed May 8, 1997, which is assigned to the present assignee and incorporated herein by reference in its entirety, the labyrinth should be dimensioned to inhibit formation of a complete conducting path from the coil to the shield. Such a conducting path could form as conductive deposition material is deposited onto the coil and standoffs. It should be recognized that other dimensions, shapes and numbers of passageways of the labyrinth are possible, depending upon the particular application. Factors affecting the design of the labyrinth include the type of material being deposited and the number of depositions desired before the standoffs need to be cleaned or replaced.

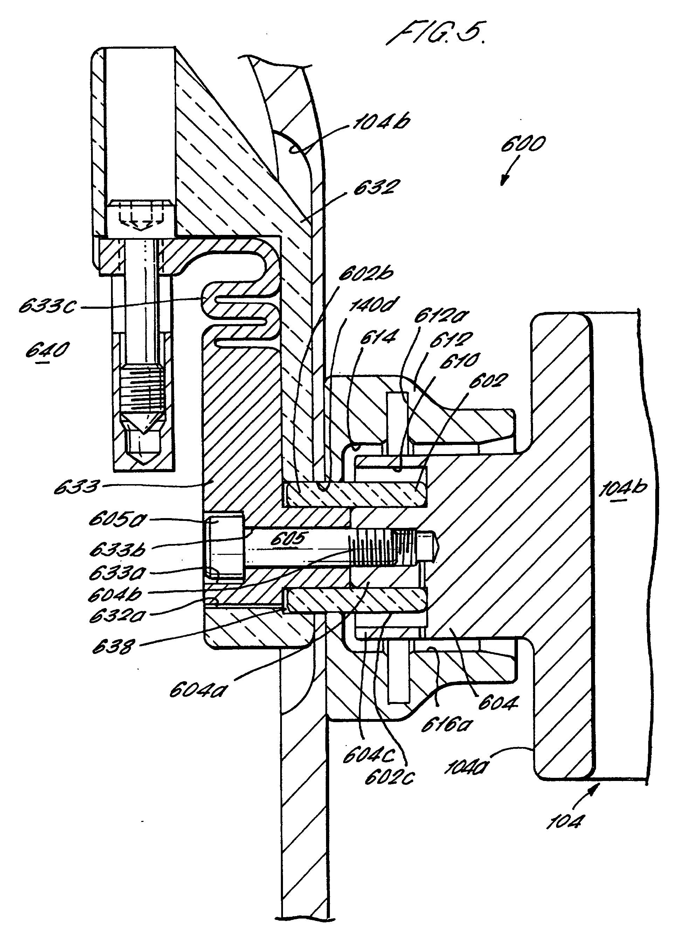

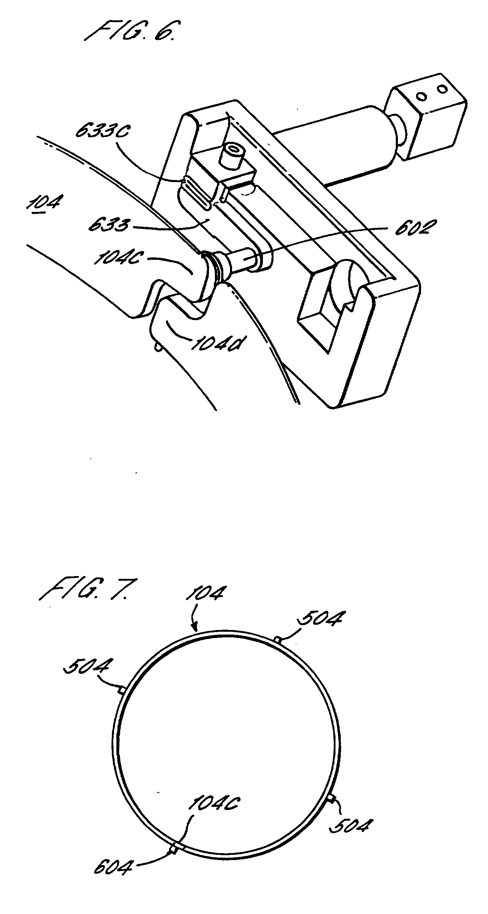

Fig. 5 is a cross-sectional view of a feedthrough standoff 600 in accordance with another aspect. Fig. 6 is a perspective view of the feedthrough standoff 600 shown without the shield wall 140 for clarity. Like the support standoff 500 of Fig. 4, the feedthrough standoff 600 includes a cylindrical electrically insulative base member 602 and a cup-shaped metal hub member 604 which is attached to the rear or outer face 104a of the coil 104 by welding. The hub member 604 has a cylindrically shaped side wall 604c spaced from the lateral side 602c of the base member 602 to form a labyrinthine passageway 610 oriented substantially transverse to the wall 140 of the shield. In addition, the standoff 600 of Fig. 5 has a second cup-shaped metal cover member 612 having a cylindrically shaped side wall 614 spaced from the side 602c of the first cover member 602 to form a second labyrinthine passageway 616a oriented generally parallel to the passageway 610 to further reduce the likelihood of the formation of a shorting conductive path. The hub member 604 and second cover member 612 of the feedthrough standoff 600 are constructed similarly to the counterpart hub member 504 and second cover member 512 of the support standoff 500.

The second cover member 612 is fastened to the shield wall 140 by screw fasteners which ensure that the second cover member 612 is tightly engaged against and in good electrical contact with the shield wall 104 and therefore grounded to retard sputtering of the first cover member 604. An annular shaped channel 612a in the second cover member is coupled to the threaded holes for the fasteners to vent gases that might inadvertently be trapped in the fastener holes.

The first electrically insulative base member 602 extends through an opening 140d in the shield wall 140. The standoff 600 further includes a second electrically insulative base member 632 positioned in a recess 140b on the outer side of the shield wall 140. Seated in a recess 632a of the the second insulative base member 632 and engaging the end of the central portion 604a of the hub member 604 is a conductive metal bar 633. Seated in a recess 633a of the conductive metal bar 633 is the head 605a of a bolt 605 which passes through interior opening 633b in the bar 633 and is threaded into the threaded bore 604b of the hub member 604 of the coil 104 on the interior side of the shield wall 140. This compresses the assembly of the standoff 600 together to insulatively secure the feedthrough standoff and coil 104 to the shield wall 140.

The first electrically insulative base member 602 insulates the bar member 633 (and the bolt 634) from the grounded shield wall 140. The second electrically insulative member 632 in turn insulates the conductive bar 633 from the grounded shield wall 140. RF current travels along the surface of the conductive bar 633 from an RF source exterior to the vacuum chamber, along the surfaces of the hub member 604 and the remainder of the coil 104. The conductive bar 633 may have a flexible portion 633c to accomodate movement of the shield and coil during deposition. A space 638 is provided between the end 602b of the insulative member 602 and the conductive bar 633 so that the compressive force of the bolt 605 and the hub member 604 does not damage the insulative members which may be made of breakable materials such as ceramics.

As set forth above, the conductive bar 633 carrying RF currents from the exterior generator to the feedthrough is seated in a second electrically insulative member 632. Covering the other side of the conductive bar 633 and the end of the bolt 634 is a third electrically insulative member 640. The electrically insulative members 632 and 640 conform around the RF conductive members to fill the available space to avoid leaving spaces larger than a darkspace to inhibit formation of a plasma and arcing from the conductive bar 633 and the bolt 605.

As best seen in Figs. 6 and 7, the coil 104 may have overlapping but spaced ends 104c and 104d to which a pair of hub members 604 are formed or attached to the rear of the coil 104. In this arrangement, the feedthrough standoffs 600 for each end may be stacked in a direction parallel to the plasma chamber central axis between the vacuum chamber target 110 and the substrate holder 114. As a consequence, the RF path from one end of the coil to the other end of the coil can similarly overlap and thus avoid a gap over the wafer. It is believed that such an overlapping arrangement can improve uniformity of plasma generation, ionization and deposition as described in copending application Serial No. 09/039,695, filed March 16, 1998 and assigned to the assignee of the present application.

The support standoffs may be distributed around the remainder of the coil to provide suitable support. In the embodiment illustrated in Fig. 7, the coil 104 has three hub members 504 distributed at 90 degree separations on the outer face 104a of the coil 104. A coil support standoff 500 may be attached to each coil hub member 504 as described above. It should be appreciated that the number and spacing of the standoffs may be varied depending upon the particular application.

Each of the embodiments discussed above utilized a single coil in the plasma chamber. It should be recognized that the present invention is applicable to plasma chambers having more than one coil. For example, the present invention may be applied to chambers having multiple coils for launching helicon waves or for providing additional sources of RF energy or deposition material.

The coil 104 of the illustrated embodiment is made of ½ by 1/4 inch heavy duty bead blasted titanium or copper ribbon formed into a single turn coil. However, other highly conductive materials and shapes may be utilized. For example, the thickness of the coil may be reduced to 1/16 inch and the width increased to 2 inches. Also, hollow tubing may be utilized, particularly if water cooling is desired.

In another aspect of the present inventions, the upper edge of the of the coil 104 adjacent the rear face 104a of the coil 104 may be beveled to form a flat angled face as indicated at 104e in Fig. 4. In the illustrated embodiment, the coil faces 104a and 104b are oriented vertically, parallel to the plasma chamber central axis between the target 110 and the substrate pedestal 114. The beveled upper face 104e is neither vertically nor horizontally oriented. Instead, the face 104e is oriented at an angle with respect to the plasma chamber vertical central axis between the target 110 and the substrate 112 and with respect to the horizontal face of the target 110 to reduce the accumulation of sputtered material onto the upper face 104e of the coil 104. In the illustrated embodiment, the beveled face is angled at an angle of approximately 59 degrees relative to the face of the target 110. As a consequence, it is believed that the accumulation of deposited material onto the coil 104 and, as a consequence, the generation of particulates, may be reduced. In a similar manner, the lower edge of the of the coil 104 adjacent the rear face 104a of the coil 104 may be beveled to form a flat, angled face as indicated at 104f. It is believed that satisfactory results may be achieved by angling the beveled faces at an angle of approximately 45-60 degrees relative to the horizontal plane.

The appropriate RF generators and matching circuits are components well known to those skilled in the art. For example, an RF generator such as the ENI Genesis series which has the capability to "frequency hunt" for the best frequency match with the matching circuit and antenna is suitable. The frequency of the generator for generating the RF power to the coil is preferably 2 MHz but it is anticipated that the range can vary at other A.C. frequencies such as, for example, 1 MHz to 100 MHz and non-RF frequencies.

In the illustrated embodiment, the shield 106 has an inside diameter of 16" but it is anticipated that good results can be obtained with a width in the range of 6"-25". The shields may be fabricated from a variety of materials including electrically insulative materials such as ceramics or quartz. However, the shield and all metal surfaces likely to be coated with the target material are preferably made of a material such as stainless steel or copper unless made of the same material as the sputtered target material. The material of the structure which will be coated should have a coefficient of thermal expansion which closely matches that of the material being sputtered to reduce flaking of sputtered material from the shield or other structure onto the wafer. In addition, the material to be cooled should exhibit good adhesion to the sputtered material. Thus, for example if the deposited material is titanium, the preferred metal of the shields, coils, brackets and other structures likely to be coated is bead blasted titanium. Of course, if the material to be deposited is a material other than titanium, the preferred metal is the deposited material, stainless steel or copper. Adherence can also be improved by coating the structures with molybdenum prior to sputtering the target.

A variety of precursor gases may be utilized to generate the plasma including Ar, H₂, O₂ or reactive gases such as NF₃, CF₄ and many others. Various precursor gas pressures are suitable including pressures of 0.1 - 50 mTorr. For ionized PVD, a pressure between 10 and 100 mTorr is preferred for best ionization of sputtered material.

It will, of course, be understood that modifications of the present inventions, in their various aspects, will be apparent to those skilled in the art, some being apparent only after study others being matters of routine mechanical and electronic design. Other embodiments are also possible, their specific designs depending upon the particular application. As such, the scope of the inventions should not be limited by the particular embodiments herein described but should be defined only by the appended claims and equivalents thereof.

## Claims

1. An apparatus for energizing a plasma within a semiconductor fabrication system by coupling energy into the plasma, the apparatus comprising:
a semiconductor fabrication chamber having a first wall at least partially defining a plasma containment region;
a coil having a first face facing said plasma containment region and a second face facing said first wall, said second face defining a fastener recess extending partially through said coil; and
a fastener member adapted to fasten said coil to said first wall wherein said coil second face fastener recess is adapted to receive said fastener member.

2. The apparatus of claim 1 wherein said fastener member is a bolt and said fastener recess is a threaded bore.

3. The apparatus of claim 1 wherein said coil second face includes a protruding member integral with said coil and defining said fastener recess.

4. The apparatus of claim 3 wherein said protruding member is welded to said coil second face.

5. The apparatus of claim 3 wherein said fastener member is a bolt and said fastener recess is a threaded bore.

6. The apparatus of claim 5 further comprising a first insulating member positioned around said bolt between said first wall and said bolt to electrically insulate said bolt from said first wall.

7. The apparatus of claim 6 wherein said first insulating member comprises an aluminum nitride material.

8. The apparatus of claim 6 wherein said protruding member defines a recess positioned to receive one end of said first insulating member, said recess being of sufficient size to define a first passageway between said protruding member and said first insulating member end.

9. The apparatus of claim 8 further comprising a conductive cup-shaped member attached to said first wall and defining a recess positioned to receive one end of said protruding member spaced from said cup-shaped member to define a second passageway between said protruding member and said cup-shaped member.

10. The apparatus of claim 9 wherein said cup-shaped member defines an opening positioned to receive the other end of said first insulating member and to electrically insulate said bolt from said cup-shaped member.

11. The apparatus of claim 6 further comprising a retainer plate which defines an opening adapted to receive a portion of said first insulating member wherein said first wall defines a recess adapted to receive said retainer plate.

12. The apparatus of claim 11 wherein said bolt has a head, said apparatus further comprising a second insulating member positioned around said bolt between said retainer plate and said bolt head to insulate said bolt from said retainer plate.

13. The apparatus of claim 12 further comprising a bushing positioned around said bolt and between said second insulating member and said bolt head.

14. The apparatus of claim 12 further comprising a third generally cap-shaped insulating member positioned around said bolt head to insulate said bolt head.

15. The apparatus of claim 1 wherein said second insulating member has a retention flange and said third insulating member has a recess positioned to receive said third insulating member flange to retain said third insulating member around said bolt head.

16. The apparatus of claim 1 wherein said first and second coil faces are oriented vertically and said coil has a beveled edge to define a nonvertical, nonhorizontal flat face between said first and second faces.

17. The apparatus of claim 1 further comprising a source of RF energy coupled to said fastener member to provide RF energy to said coil.

18. The apparatus of claim 2 wherein said bolt has a head, said apparatus further comprising a second insulating member positioned around said bolt head to insulate said bolt from said first wall.

19. The apparatus of claim 18 wherein the system includes a source of RF energy, said apparatus further comprising an RF conductor member adapted to couple RF energy from said RF source to said bolt head to provide RF energy to said coil, wherein said second insulating member is positioned between said conductor member and said first wall to insulate said conductor member from said first wall.

20. The apparatus of claim 1 further comprising a target adapted to provide sputtered deposition material and a substrate holder positioned to hold a substrate to receive said sputtered deposition material from said target.

21. The apparatus of claim 1 wherein said first wall is a generally cylindrical shield wall positioned between said target and said substrate holder.

22. A kit for a semiconductor fabrication chamber, comprising:
a generally cylindrical shield wall defining a plurality of apertures and a plurality of recesses, each recess being positioned adjacent an associated aperture;
a generally circular RF coil having an outer face facing said shield wall, said coil further having a plurality of hub members extending integrally from said outer face, each hub member defining a threaded bore extending partially through said coil hub member of said coil; and
a plurality of standoffs fastened to an associated coil hub member, each standoff comprising
a bolt extending through a shield wall aperture and having a head on one side of the shield wall and a threaded end on the other side of the shield wall and threaded into a threaded bore of the associated coil hub member; and
a first generally cylindrical aluminum nitride insulating member being positioned around said bolt between said shield wall and said bolt to electrically insulate said bolt from said shield wall, wherein said hub member defines an annular recess positioned to receive one end of said first insulating member, said hub member recess being of sufficient size to define a passageway between said protruding member and said first insulating member end.

23. The kit of claim 22 wherein each standoff further comprises a second generally cylindrical insulating member positioned around said bolt between said shield wall and said bolt head to electrically insulate said bolt from said shield wall.

24. The kit of claim 23 wherein each standoff further comprises a retainer plate which defines an opening positioned to receive a portion of said first insulating member wherein an associated shield wall recess is positioned to receive said retainer plate and wherein said second insulating member is positioned to insulate said bolt from said retainer plate, each standoff further comprising a bushing positioned around said bolt and between said second insulating member and said bolt head.

25. The kit of claim 23 wherein an associated shield wall recess is positioned to receive said second insulating member.

26. The kit of claim 22 further comprising a conductor bar which defines an opening adapted to receive said bolt, said conductor bar being adapted to be coupled to a source of RF energy, wherein said second insulating member is positioned between said conductor bar and said shield wall to electrically insulate said conductor bar from said shield wall.

27. An apparatus for energizing a plasma within a semiconductor fabrication system by coupling energy into the plasma, the apparatus comprising:
a semiconductor fabrication chamber having a first wall at least partially defining a plasma containment region;
a coil having a first face facing said plasma containment region and a second face facing said first wall, said second face including a protruding member integral with said coil; and
a fastener adapted to fasten said coil protruding member to said first wall.

28. The apparatus of claim 27 wherein said fastener comprises a threaded bolt and said coil protruding member defines a threaded bore adapted to threadably receive said bolt.

29. A coil for energizing a plasma within a semiconductor fabrication chamber having a first wall at least partially defining a plasma containment region, the coil comprising:
an elongated coil member having a first face adapted to face said plasma containment region and a second face adapted to face said first wall when installed in said chamber, said second face including a protruding coupler member integral with said coil.

30. An apparatus for energizing a plasma within a semiconductor fabrication system by coupling energy into the plasma, the apparatus comprising:
a semiconductor fabrication chamber having a first wall at least partially defining a plasma containment region;
a standoff carried by said first wall; and
a coil carried by said standoff, said coil being adapted to inductively couple RF energy into said plasma;
wherein said standoff includes an aluminum nitride insulative member positioned to electrically insulate said coil from said first wall and to thermally couple said coil to said first wall.

31. A method of fastening an RF coil to a shield wall for a semiconductor fabrication chamber, the method comprising:
placing an insulative member around a fastener member;
inserting the fastener member through an aperture in said shield wall; and
fastening said fastener member to a fastener recess defined by an outer face of said coil and extending partially through said coil.

32. A method of fastening an RF coil to a shield wall for a semiconductor fabrication chamber, the method comprising:
placing an insulative member around a fastener member;
inserting the fastener member through an aperture in said shield wall; and
fastening said fastener member to a protruding member extending integrally from an outer face of said coil.

33. A method of fastening an RF coil to a shield wall for a semiconductor fabrication chamber, the method comprising:
placing a first generally cylindrical aluminum nitride insulating member in an annular recess defined by a hub member extending integrally from an outer face of a generally circular coil;
placing a second generally cylindrical insulative member around a threaded bolt;
inserting the threaded bolt through an aperture in said shield wall so that said second insulative member is positioned between said bolt and an outer side of said shield wall; and
threading said threaded bolt into a threaded bore of a hub member extending integrally from an outer face of said coil so that said first insulating member is positioned between said bolt and an interior side of said shield wall.

34. The method of claim 33 further comprising positioning a retainer plate in a recess on the outer side of said shield wall, and passing a portion of said first insulating member through an opening defined by said retainer plate wherein said second generally cylindrical insulating member is positioned around said bolt between said retainer plate and said bolt head to insulate said bolt from said retainer plate.

35. The method of claim 34 further comprising positioning a bushing around said bolt and between said second insulating member and said bolt head.

36. The method of claim 33 further comprising positioning said second insulating member in a recess of the shield wall.

37. The method of claim 36 further comprising passing the threaded bolt through an opening defined by a conductor bar, said conductor bar being adapted to be coupled to a source of RF energy, and positioning said second insulating member between said conductor bar and said shield wall to insulate said conductor bar from said shield wall.

38. An apparatus for energizing a plasma within a semiconductor fabrication system by coupling energy into the plasma, the apparatus comprising:
a semiconductor fabrication chamber having a first wall at least partially defining a plasma containment region;
a coil having a first face facing said plasma containment region and a second face facing said first wall, said second face including a protruding member integral with said coil; and
fastener means for insulatively fastening said coil protruding member to said first wall.
